Europäisches Patentamt

European Patent Office

Office européen des brevets

(19)

(11) Numéro de publication: **0 033 298**
A1

# (12) DEMANDE DE BREVET EUROPEEN

(21) Numéro de dépôt: **81810003.4**

(22) Date de dépôt: **06.01.81**

(51) Int. Cl.³: **C 03 C 25/02**
**C 23 C 11/00**

(30) Priorité: **09.01.80 CH 128/80**

(43) Date de publication de la demande:
**05.08.81 Bulletin 81/31**

(84) Etats contractants désignés:
**AT BE CH DE FR GB IT LI NL SE**

(71) Demandeur: **BATTELLE MEMORIAL INSTITUTE**
**7 route de Drize**
**CH-1227 Carouge/Genève(CH)**

(72) Inventeur: **Kalbskopf, Reinhard**
**103, Avenue du Bois de la Chapelle**
**CH-1213 Onex(CH)**

(74) Mandataire: **Dousse, Blasco et al,**
**7, route de Drize**
**CH-1227 Carouge/Genève(CH)**

(54) **Fibre de verre protégée contre la corrosion et un procédé d'obtention de celle-ci.**

(57) Fibre en verre ou quartz résistant à la corrosion par l'humidité et l'alcali et pouvant être employée dans les guides optiques et pour renforcer le ciment. Pour la fabriquer, on fait circuler un fil de verre fraîchement étiré et encore chaud à proximité immédiate d'une masse poreuse imbibée d'une solution d'un ou plusieurs composés dont la décomposition, sous l'effet de la chaleur du fil, engendre la formation d'une couche d'oxyde minéral se déposant sur le fil.

EP 0 033 298 A1

./...

## FIBRE DE VERRE PROTEGEE CONTRE LA CORROSION ET UN PROCEDE D'OBTENTION DE CELLE-CI

### Domaine technique

La présente invention a pour objet une fibre ou filament de verre ou de quartz muni d'un revêtement anti-corrosion en $SnO_2$ de 10 à 100 nm d'épaisseur et un procédé pour revêtir un filament de verre d'un tel revêtement de $SnO_2$.

### Technique antérieure

L'application d'un revêtement minéral sur la surface des objets en verre en vue de les protéger contre les chocs et l'abrasion est bien connue. Ainsi, on peut diminuer la fragilité d'articles en verre creux en les revêtant, par vaporisation, d'une couche d'oxyde d'étain de l'ordre de 10 nm (Glastechn. Ber. 49 (1976) [3], 43-52). Dans le domaine des filaments et fibres de verre utilisés dans le domaine optique ou comme renforts mécaniques des matériaux de construction, les revêtements minéraux permettent d'obvier au processus d'affaiblissement des propriétés mécaniques qui affecte ces fibres au cours du temps. On sait, par exemple, que des fibres de verre destinées à armer le béton et dont la résistance à la rupture à l'état fraîchement étiré est de l'ordre de la tonne au $mm^2$ perdent leur solidité en vieillissant, cette résistance pouvant tomber à quelques 100 $kg/mm^2$. Les mêmes problèmes se posent pour les guides optiques en fibre de verre à indice de réfraction variable, ces guides pouvant se rompre avec le temps dans les conditions usuelles d'utilisation: variation de température, atmosphère humide, agents extérieurs de corrosion, etc... On pense que ce vieillissement est dû à la lente propagation, dans le corps des fibres, des microfissures de surface qui se forment lors de l'étirage et du bobinage desdites fibres. Un revêtement desdites fibres, notamment de $Si_3N_4$, BN, $SnO_2$ et $TiO_2$, qu'on dépose par exemple par la méthode de dépôt en phase vapeur (CVD), permet de conserver à ces fibres, au cours du temps, les propriétés mécaniques qu'elles possèdent immédiatement après leur étirage (voir brevet USP 4,118,211).

Il existe plusieurs méthodes pour appliquer un revêtement minéral sur des fibres de verre. Ainsi, le brevet français No 2.320.915, qui concerne des filaments contenant plus de 95 % de $SiO_2$, en décrit trois : Dans la première (a), on mouille le fil fraîchement étiré par une solution d'un composé métallique (par exemple $Ti(iso.PropO)_4$ dans un solvant organique) et on fait circuler ce fil ainsi mouillé dans un four chauffé à une température convenable pour que le composé métallique se transforme en oxyde correspondant qui se fixe sur le fil.

Dans la seconde (b), qui s'applique plus particulièrement à la fabrication des filaments de verre par étirage au chalumeau de baguettes de verre, on envoie dans la flamme de celui-ci un composé métallique volatil dont la décomposition, par la chaleur, fournit l'oxyde désiré.

Dans la troisième méthode (c), on fait passer le fil sortant de filière et encore chaud dans une enceinte dans laquelle on fait circuler un courant gazeux contenant le composé métallique volatil à décomposer. Au contact du fil chaud, une fraction de ce composé métallique vaporisé se décompose et se dépose, sous forme d'oxyde, à la surface dudit fil.

Les trois méthodes ci-dessus ne sont, cependant, pas dépourvues d'inconvénients. En effet, les méthodes (a) et (b) sont extrêmement difficiles à maintenir sous contrôle et fournissent souvent des dépôts irréguliers, particulièrement dans les cas où on dépose du $SnO_2$. Quant à la méthode (c) elle conduit, en l'absence d'un chauffage additionnel du fil à l'intérieur de l'enceinte, à des rendements extrêmements faibles à cause des pertes presque instantanées de chaleur qui se produisent lorsque le fil sortant d'étirage rencontre le courant gazeux chargé du composé métallique volatil mais qui contient, de par nécessité, une proportion importante de gaz porteur inerte.

Par ailleurs, la publication suivante: Japon Kokai 76, 113.300 mentionne la fabrication de fibres de verre comportant un revêtement de $SnO_2$, ce revêtement étant obtenu par contact de celles-ci avec une vapeur de $Me_2SnCl_2$. Il est également mentionné que de telles fibres ont une résistance supérieure à celle de fibres non traitées après 1 heure dans de l'eau à 70%. Dans de telles conditions l'attaque des fibres protégées n'était que le 37% de l'attaque des fibres non protégées.

Cependant, un tel degré de protection n'est pas encore jugé suffisant et la présente invention permet de fournir des fibres ou filaments de verre muni d'un manchon de $SnO_2$ dont la résistance à la corrosion est encore améliorée. En effet, la fibre ou filament de l'invention muni de son manchon protecteur en $SnO_2$ offre une protection telle qu'elle reste pratiquement inaltérée après 16 semaines d'immersion sous tension dans une solution de pH 13 à 20-60°C. Dans les mêmes conditions la même fibre non protégée est complètement rompue. La tension à laquelle la fibre est soumise dans ce test est de l'ordre de 3 à 6 $kg/mm^2$.

La présente invention se propose également de remédier aux inconvénients de la méthode (c) décrite ci-dessus sans avoir à chauffer le courant de gaz et du produit à décomposer, c'est à dire sans avoir à recourir aux conditions classiques de la technique CVD telles que décrites, par exemple, dans la référence déjà mentionnée plus haut, le brevet US No 4,118,211 et dans la publication japonaise: Nippon Kagaku Kaishi 8 (1978), (2), 170-174.

### Description de l'invention

Dans le procédé de l'invention destinée à fabriquer la fibre susmentionnée, on fait circuler la fibre sortant d'étirage à la proximité immédiate d'une masse poreuse imbibée d'un liquide contenant le composé métallique à décomposer, ceci de manière que la chaleur du fil, et ceci sans chauffage d'appoint, provoque l'évaporation d'une portion de celui-ci, sa décomposition et la fixation sur le fil d'une couche de l'oxyde correspondant. Par le terme de "proximité immédiate" on entend que le fil passe aussi près qu'on le désire de ladite masse poreuse, étant bien compris qu'au cas où le fil toucherait ladite masse, la perte de chaleur occasionnée par contact et frottement avec le support poreux ne soit pas telle que la vaporisation du produit clé devienne insuffisante ou nulle. Il est aussi bien entendu qu'il ne s'agit nullement de mouiller le fil de la solution sus-mentionnée comme dans les procédés connus ci-desus ce qui conduirait, dans les conditions opératoires de la présente invention et, notamment avec le composé d'étain, à la formation d'un revêtement blanchâtre et pulvérulent défecteux et inutilisable, mais bien de faire en sorte que le fil soit, en permanence, entouré d'un coussin de la vapeur, seule, du produit clé dont la décomposition fournit l'oxyde recherché.

Il faut cependant mentionner qu'il existe déjà des méthodes similaires pour déposer des revêtements sur des articles filamentaires ou autres. Ainsi, le brevet allemand No 533.644 décrit une méthode pour mettre en contact un fil métallique avec des vapeurs de composés de revêtement. Suivant cette méthode, on chauffe électriquement ce fil et on le fait circuler à travers une masse poreuse imbibée d'un liquide contenant la substance à vaporiser, la chaleur du fil provoquant l'évaporation de cette substance et sa réaction sur le fil à plaquer.

Par ailleurs, le brevet français No 2.090.384 décrit un procédé de dépôt d'un revêtement inorganique sur une pièce à partir d'une phase vapeur de substances décomposables métalliques ou non métalliques liquides, par exemple de composés de silicium, de germanium ou de bore, notamment sous forme de solutions ou de suspensions de composés volatils d'éléments utilisés soit conjointement, soit séparément, la surface de ladite pièce à revêtir étant portée au cours du dépôt, à une température à laquelle lesdits éléments ou leurs composés à déposer se dégagent desdites substances liquides décomposables, caractérisé en ce que l'on fait passer par gravité ledit liquide décomposable au voisinage de la surface à revêtir de ladite pièce disposée par rapport au liquide décomposable, à une distance assurant l'échauffement et l'évaporation desdits éléments ou de leurs composés sous l'action du rayonnement thermique émis par la pièce à revêtir, et la formation d'une phase vapeur sur toute l'étendue de ladite pièce. Il s'avère, cependant, à la lecture de ce brevet que ce procédé n'est pas appliqué au dépôt de revêtement sur des fibres de verre et que son adaptation à un tel dépôt ne peut être envisagée sans autre par l'homme de métier.

Il reste donc évident que le présent procédé, adapté au revêtement des fibres et filaments de verre d'une couche d'oxyde métallique, constitue une contribution importante aux progrès de la technique.

## Meilleures manières de réaliser l'invention

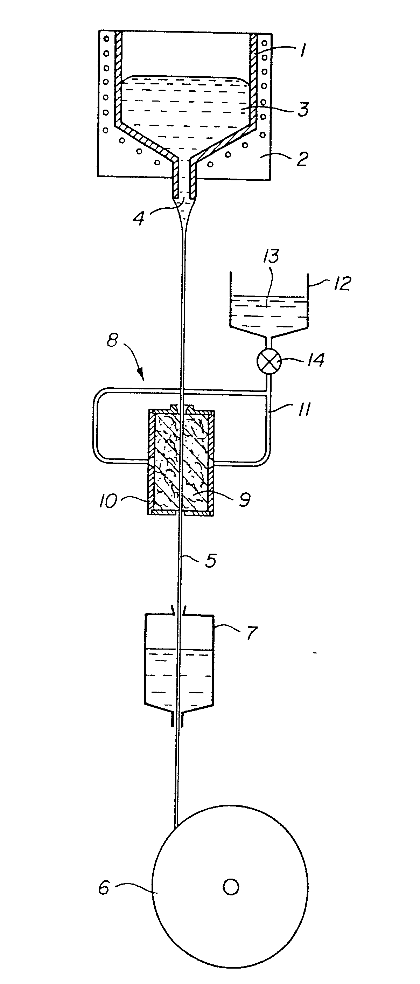

L'invention sera mieux comprise au moyen du dessin en annexe dans lequel la fig. unique représente, schématiquement, une installation d'étirage de fils de verre munie d'un dispositif pour réaliser l'invention.

L'installation représentée comprend un creuset 1, par exemple en alliage Pt-Rh, chauffé par un four 2 de modèle classique quelconque, par exemple à résistances ou à induction, ledit creuset 1 contenant une masse de verre 3 en fusion et maintenue à une température convenable pour qu'on puisse l'étirer en filaments. Le creuset comporte un orifice vertical inférieur 4 par lequel le verre fondu peut s'écouler et ainsi donner naissance, par étirage, à un filament de verre 5.

L'installation comporte encore, schématiquement représentés, un tambour d'enroulement du filament 6, et, disposés à proximité immédiate du filament et entourant celui-ci un récipient d'ensimage 7 et un dispositif 8 permettant de mettre l'invention en oeuvre. Le dispositif 8 se compose essentiellement d'une masse poreuse 9, d'un organe de support 10 de cette masse poreuse, de conduits 11 pour alimenter en liquide ladite masse poreuse et d'un réservoir 12 de ce liquide 13. Le dispositif comprend encore une vanne 14 pour ajuster le débit du liquide en fonction de son taux de consommation.

Le tambour 6 et le récipient d'ensimage sont tout à fait classiques et ne contribuent qu'indirectement à la réalisation de l'invention; ils ne méritent donc pas une attention particulière.

En ce qui concerne la masse poreuse 9, celle-ci peut être constituée d'une matière inerte douée d'une capacité de rétention d'un liquide par capillarité. Comme telle, on peut utiliser une matière poreuse minérale ou organique, à condition que, dans ce dernier cas, elle résiste aux températures élevées: Les polymères fluorés peuvent, par exemple, convenir. De préférence la masse poreuse 9 est constituée d'une laine ou poudre minérale, par exemple de graphite, de kaolin, d'alumine, etc.. S'il s'agit d'une poudre, celle-ci doit, de préférence, être à l'état aggloméré afin de ne pas être entraînée accidentellement par la fibre de verre en mouvement. S'il s'agit d'une laine ou d'un feutre fait de fibres minérales, l'ensemble présente une homogénéité intrinsèque suffisante pour que le support cylindrique 10 du dessin, comportant des faces parallèles centralement perforées, puisse être réduit à un simple tube ouvert aux deux bouts ou même à une simple plaquette sur laquelle on a fixé le feutre par collage. De préférence, la masse poreuse doit avoir un coefficient de frottement aussi faible que possible et, pour cette raison on préfère utiliser le graphite quoique des agglomérés poreux de cuivre, d'oxyde d'aluminium ou de $MoS_2$ puissent aussi convenir.

Le liquide 13 qui sert à humecter la masse poreuse 9 est une solution d'un composé qui, à la chaleur, se décompose et forme un ou plusieurs oxydes métalliques se déposant sur la fibre. Comme tel, on peut utiliser des solutions de composés métalliques minéraux ou organiques. Par exemple, pour déposer $SnO_2$, on peut utiliser des solutions d'alcoyle-étain dans un solvant inerte, d'alcoxyde-étain, d'acétate d'étain-dibutyle, de $SnCl_4$, etc... dans des solvants organiques tels que des alcools aliphatiques inférieurs, notamment le méthanol. On peut, si désiré, aussi déposer $TiO_2$ et, dans ce cas, on peut prendre $TiCl_4$, $(BuO)_4Ti$, $(iso-PropO)_4Ti$, etc. dans un solvant comme $CHCl_3$, par exemple. Aussi, de manière générale, on pourra utiliser les mêmes solutions communément employées pour le dépôt d'oxydes métalliques par pulvérisation suivant les techniques classiques. Pour le dépôt d'autres oxydes, isolément ou en mélanges, le praticien n'aura pas de peine à choisir une solution appropriée en fonction des besoins et à partir des données de la littérature.

De manière très générale, on procède comme suit au moyen de l'installation représentée au dessin : on place le verre choisi dans le creuset 1 et on le chauffe de manière qu'il entre en fusion. La sorte de verre qu'on peut utiliser n'est pas critique et la plupart des verres habituels, riches ou pauvres en $SiO_2$ de même que le quartz, peuvent convenir à condition qu'on puisse les étirer en filaments. On pourrait d'ailleurs utiliser une autre méthode d'étirage, à partir d'un barreau chauffé dans une flamme, par exemple. De préférence, cependant, on choisira des verres ayant une température d'étirage de 1100 à 2000°C environ, de manière que le filament ait une température favorable au moment où il passe au contact de la masse poreuse humide 9.

Une fois le verre fondu et à la température convenable, il tend à s'écouler par l'orifice 4 et on l'étire alors, à une vitesse appropriée pour qu'il se forme un filament qu'on enroule progressivement sur le tambour 6. Avant de parvenir au tambour 6, le fil passe sucessivement dans le dispositif 8 et dans l'ensimeur 7. Le dispositif 8 est placé à une distance convenable de l'orifice 4 pour que le filament déjà durci mais encore très chaud provoque, par son passage au voisinage immédiat de la masse poreuse 9, une évaporation locale de la solution dont cette masse est imbibée en continu, la décomposition du composé métallique qu'elle contient et le dépôt, sur le fil, d'une mince couche d'oxyde dudit métal. On a constaté que le mouvement du fil au contact de la masse poreuse 9 produit, aérodynamiquement, des conditions de turbulence favorables à un dépôt régulier et homogène d'oxyde métallique. Pour parvenir sûrement à cet effet, on a donc rempli le réservoir 12 de la solution adéquate, et on a réglé la vanne 14 de manière que, tenu compte de la consommation progressive de solution lors du dépôt de l'oxyde sur le filament, la masse poreuse reste constamment humectée par la solution dans la zone se trouvant à proximité immédiate dudit filament. Il est bien entendu qu'on pourra régler l'épaisseur de la couche d'oxyde en admettant plus ou moins de liquide à travers la vanne 14, mais ceci dans certaines limites à ne pas outrepasser. En effet, si le débit est trop fort, le dépôt devient pulvérulent, opaque et irrégulier alors que s'il est trop faible, la masse poreuse tend à sécher et le dépôt devient insuffisant. De manière générale, il est bon que la température du filament au moment où il passe dans le dispositif 8 soit d'environ 400 à 800°C et que le débit de liquide dans la mousse poreuse soit tel qu'il permette une consommation de dérivé métallique convenable pour que l'épaisseur du dépôt soit de l'ordre de 5 à 20 nm, la vitesse d'étirage étant de 5 à 30 m/sec et le fil ayant environ 10 à 50 $\mu$ d'épaisseur. Bien entendu, ces valeurs ne sont données qu'à titre indicatif et peuvent être modifiées profondément en fonction d'autres paramètres tels que le choix du solvant, celui du ou des composés métalliques, de la concentration de ceux-ci et de la nature de la matière poreuse utilisée. Aussi, tous ces facteurs pourront être facilement déterminés par l'homme de métier mettant l'invention en oeuvre et en fonction des résultats recherchés.

L'exemple suivant illustre l'invention.

## Application industrielle

On a placé 200 g d'un verre de composition : $SiO_2$ 55,2%; $Al_2O_3$ 14,8%; $B_2O_3$ 7,3%; MgO 3,3%; CaO 18,7%; $Na_2O$ 0,3%; $K_2O$ 0,2%; $Fe_2O_3$ 0,3%; $F_2$ 0,3% dans le creuset d'une installation conforme, schématiquement, au dessin, ce creuset ayant une capacité d'environ 200 ml. On a chauffé le creuset de manière que le verre fonde et soit porté à une température de 1550°C, puis on a procédé à l'étirage de ce verre sous forme d'un monofilament d'environ 20 $\mu$ à la vitesse de 15 m/sec. On a fait passer ce fil, à la sortie de la buse d'étirage, dans un dispositif, conforme à la description qui précède, se composant de deux plaquettes d'environ 5 cm de haut se faisant vis à vis et garnies d'une épaisseur d'environ 1 cm de feutre de graphite. L'espace disponible entre les deux tampons de feutre pour le passage du fil était d'environ 0,5- 2.0 mm. Ces revêtements de feutre étaient alimentés en continu, par l'intermédiaire de gouttes à gouttes réglés par des robinets, par une solution contenant, en poids, 33 % de $SnCl_4$, 47 % de $CH_3OH$, 14 % d'HCl aqueux concentré et 6 % d'eau. La température du fil, lors de son passage entre les tampons de feutre, était d'environ 500°C ce qui a conduit à la formation d'un revêtement homogène de $SnO_2$ d'environ 10 nm sur toute la surface du fil. Cette symétrie de formation du dépôt indique clairement que celui-ci ne résulte pas d'un mouillage du fil par le liquide contenu dans le feutre de graphite, mais bien de la création, sous l'influence de la chaleur dégagée par le fil, d'un nuage de vapeur du produit à décomposer, ce nuage se répartissant régulièrement autour du fil en engendrant la formation d'oxyde sur toute la périphérie de celui-ci. Si le processus dépendait du mouillage du fil, il se formerait vraissemblablement, de par la conformation du dispositif 8 employé dans cet exemple, deux zones de dépôt diamétralement opposées de part et d'autre du fil, l'épaisseur du dépôt sur ces zones étant variable en fonction des mouvements latéraux du fil pendant l'étirage (vibrations perpendiculaires à son déplacement) et, par cela, du degré de contact entre celles-ci et les tampons de feutre déposés parallèlement et se faisant face.

Une fois le fil revêtu du dépôt d'oxyde d'étain, on l'a recouvert, par passage dans le récipient d'ensimage, d'une pellicule de matière organique, par exemple une cire siliconée, afin d'améliorer son glissement avant de l'enrouler sur le tambour 6.

Le fil obtenu par le présent procédé présentait une surface lisse de faible coefficient de frottement, même sans ensimage. Sa résistance à la rupture était d'environ 400 kg/mm$^2$, cette résistance demeurant stable avec le temps.

Sa résistance à l'humidité et aux alcalis était nettement supérieure à celle du même fil, témoin, non revêtu de la couche de SnO$_2$, ce qui a permi de l'utiliser avantageusement comme fibre de renforcement pour armer le béton. Les essais, pour démontrer cette supériorité ont consisté à suspendre un poids de 1 g à une longueur de 20 cm des filaments obtenus comme décrit ci-dessus et d'immerger le tout dans une solution alcaline de pH 13. Cette solution a été obtenue à partir de 1 kg de ciment Portland dispersé dans 1 litre d'eau, puis filtration des solides. Après 16 semaines à 20°C, 40°C et 60°C, on a compté le nombre de filaments ayant résisté à la corrosion (qui ne se sont pas rompus). Les résultats sont consignés ci-dessous (chaque essai comprenait cinq filaments).

| Nombre de filaments intacts | | Température °C |
|---|---|---|
| revêtus de SnO$_2$ | témoins | |
| 5 | 1 | 20 |
| 5 | 0 | 40 |
| 1 | 0 | 60 |

Les filaments obtenus suivant le présent exemple présentaient une conductibilité électrique non négligeable; par exemple un faisceau d'environ 100 filaments de 15-20 avait une résistance de l'ordre de 1 MΩ pour une longueur de 3 cm. En ajoutant, dans la solution de SnCl$_4$ décrite plus haut 1% en poids de SbCl$_5$, on a pu abaisser cette résistance à 1 kΩ environ.

Par ailleurs, on a pu utiliser des fibres de verre revêtues de SnO$_2$ pour confectionner des panneaux isolants ayant un fort pouvoir réflectif dans l'IR, ce qui constitue un avantage marqué comparé aux même panneaux contenant de la fibre de verre ordinaire.

Lorsque, dans les essais ci-dessus, on a employé, à la place de verre ordinaire, des fibres optiques en verre à indice de réfraction variable on a obtenu des fibres dont la résistance au vieillissement est excellente et qui ne se rompent pas sous tension, même pour des sections de grandes longueurs exposées plusieurs mois à l'humidité.

0033298

- 11 -

## REVENDICATIONS

1. Fibre de verre ou de quartz munie d'un manchon de protection en $SnO_2$ de 10 à 100 nm d'épaisseur offrant une protection anti-corrosion telle que ladite fibre est pratiquement inaltérée après 16 semaines d'immersion dans une solution aqueuse de pH 13 à 20-60°C sous une tension telle que, dans les mêmes conditions, la même fibre non protégée soit rompue.

2. Procédé pour obtenir une fibre ou un filament de verre ou de quartz suivant la revendication 1, par dépôt d'un revêtement de $SnO_2$, caractérisé par le fait qu'on fait circuler ce filament, dès après qu'il ait été étiré et sans prévoir de chauffage d'appoint, à proximité immédiate d'une masse poreuse imbibée d'un liquide contenant, dissous, un composé d'étain dont la décomposition thermique fournit ledit oxyde, le tout de manière que la chaleur du fil fraîchement étiré provoque l'évaporation d'une portion dudit liquide ainsi que la décomposition en oxyde du composé métallique entrainé par cette vapeur et le dépôt de celui-ci sur le fil sous forme d'une couche d'oxyde homogène.

3. Procédé suivant la revendication 1, caractérisé par le fait que ledit liquide contient un solvant organique et un composé choisi parmi $Sn(Alk)_4$, $Sn(OAlk)_4$, Alk étant un alcoyle inférieur, et $SnCl_4$, l'oxyde formé étant du $SnO_2$.

4. Procédé suivant la revendication 1, caractérisé par le fait que le filament chaud est, ou non, en contact physique avec ladite masse poreuse lors de son passage au voisinage immédiat de celle-ci, mais que seule la présence, au contact du fil, des vapeurs résultant de l'évaporation dudit liquide, et non pas de celui-ci en tant que tel, est la cause de la formation dudit oxyde sur la surface du fil.

5. Procédé suivant la revendication 1, caractérisé par le fait que la masse poreuse est un agglomérat de particules ou de fibres organiques ou minérales, notamment un feutre de fibres de graphite.

6. Procédé suivant la revendication 1, caractérisé par le fait qu'on utilise du verre de silice et à base de silicates étirable entre 1100 et 2000°C, que la vitesse d'étirage est de 5 à 30 m/sec, que l'épaisseur du filament est de 10 à 50 $\mu$ et que la température de dépôt du revêtement est de 400 à 800°C.

7. Fibre de verre recouverte de $SnO_2$ suivant la revendication 1, caractérisée par le fait qu'elle est résistante à l'attaque chimique du ciment et qu'elle présente une conductibilité électrique significative.

8. Installation pour la mise en oeuvre du procédé suivant la revendication 2, comprenant un creuset de verre fondu pourvu d'un orifice inférieur par lequel s'écoule ce verre qui est alors étiré en forme de fibres, et des moyens pour enrouler et stocker cette fibre, caractérisée par le fait qu'elle comporte, intercalée entre le creuset et lesdits moyens de stockage, une masse poreuse à travers laquelle passe cette fibre, cette masse étant imprégnée d'un liquide dont les vapeurs fournissent, au contact du filament, le revêtement de $SnO_2$, et, alimentant en liquide de manière réglable ladite masse poreuse, un réservoir dudit liquide.

0033298

**Office européen des brevets**

**RAPPORT DE RECHERCHE EUROPEENNE**

Numéro de la demande

EP 81 81 0003

| | DOCUMENTS CONSIDERES COMME PERTINENTS | | CLASSEMENT DE LA DEMANDE (Int. Cl ³) |
|---|---|---|---|
| Catégorie | Citation du document avec indication, en cas de besoin, des parties pertinentes | Revendication concernée | |
| D | DE - C - 533 644 (PATENT TREUHAND GESELLSCHAFT)<br><br>* Page 1, ligne 50 - page 2, ligne 14; figures *<br><br>-- | 1,4 | C 03 C 25/02<br>C 23 C 11/00 |
| | CHEMICAL ABSTRACTS, vol. 86, 1977, réf. 33554n, page 249<br>Columbus, Ohio, US<br><br>& JP - A - 76 116300 (CHUGOKU MARINE PAINTS) 13-10-1976<br>* Résumé *<br><br>-- | 1,7 | |
| | CHEMICAL ABSTRACTS, vol. 88, 1978, page 279, réf. 140861y<br>Columbus, Ohio, US<br><br>& JP - A - 77 99396 (MATSUSHITA ELECTRIC WORKS LTD)20-08-1977<br>* Résumé *<br><br>-- | 1,3,7 | DOMAINES TECHNIQUES RECHERCHES (Int. Cl. ³)<br><br>C 03 C 25/02<br>C 23 C 16/54 |
| | FR - A - 2 090 384 (INSTITUT KHIMII AKADEMII NAUK)<br>* Revendication 1; figure *<br><br>-- | 1,2 | |
| A | US - A - 3 540 870 (PEI CHING LI)<br><br>---- | | CATEGORIE DES DOCUMENTS CITES<br><br>X: particulièrement pertinent<br>A: arrière-plan technologique<br>O: divulgation non-écrite<br>P: document intercalaire<br>T· théorie ou principe à la base de l'invention<br>E: demande faisant interférence<br>D· document cité dans la demande<br>L document cité pour d'autres raisons<br><br>&: membre de la même famille. document correspondant |

Le présent rapport de recherche a été établi pour toutes les revendications

| Lieu de la recherche | Date d'achevement de la recherche | Examinateur |
|---|---|---|
| La Haye | 28-04-1981 | BOUTRUCHE |

OEB Form 1503.1  06.78